Europäisches Patentamt

**European Patent Office**

**Office européen des brevets**

(19)

(11) Numéro de publication: **0 231 550**

**A1**

(12) **DEMANDE DE BREVET EUROPEEN**

(21) Numéro de dépôt: **86202320.7**

(22) Date de dépôt: **18.12.86**

(51) Int. Cl.³: **H 03 K 19/177**

(30) Priorité: **31.12.85 FR 8519478**

(43) Date de publication de la demande:
**12.08.87 Bulletin 87/33**

(84) Etats contractants désignés:
**CH DE FR GB IT LI NL**

(71) Demandeur: **RTC-COMPELEC**
**130, Avenue Ledru-Rollin**
**F-75011 Paris(FR)**

(84) Etats contractants désignés:
**FR**

(71) Demandeur: **N.V. Philips' Gloeilampenfabrieken**
**Groenewoudseweg 1**
**NL-5621 BA Eindhoven(NL)**

(84) Etats contractants désignés:
**CH DE GB IT LI NL**

(72) Inventeur: **Bunisset, Jacques**
**Société Civile SPID 209 rue de l'Université**
**F-75007 Paris(FR)**

(72) Inventeur: **Labrousse, Jean-Michel**
**Société Civile SPID 209 rue de l'Université**
**F-75007 Paris(FR)**

(74) Mandataire: **Pinchon, Pierre et al,**
**Société Civile S.P.I.D. 209 rue de l'Université**
**F-75007 Paris(FR)**

(54) **Réseau programmable en logique dynamique et son application.**

(57) Réseau programmable (PP) réalisé en logique dynamique (CMOS) initialisé par un signal de départ (TOP) et ensuite auto-régulé au moyen d'une part d'une ligne supplémentaire de résultat (RSC) pour détecter la fin de la précharge et, dans ce cas, commander le début de l'évaluation (TR-E1), d'autre part d'une autre ligne supplémentaire de résultat (RSD) pour détecter la fin de l'évaluation et, dans ce cas, généer un signal (RDY1) indiquant que les signaux présents sur les lignes de résultat (R1, R2, R3) sont valides et stables.

Cascade auto-régulée de réseaux, notamment réseau logique programmable (PLA)

FIG.1

EP 0 231 550 A1

"RESEAU PROGRAMMABLE EN LOGIQUE DYNAMIQUE ET SON APPLICATION".

La présente invention a pour objet un réseau programmable réalisé en logique dynamique sur un substrat semi-conducteur, comportant 'n' (n entier positif) lignes d'entrée disposées pour croiser 'p' (p entier positif) lignes de résultat, 'k' ($1 \leqslant k \leqslant n.p$) transistors de sélection prévus ou non à chaque croisement de chacune des dites lignes d'entrée avec chacune des dites lignes de résultat, chaque ligne de résultat ayant une capacité équivalente réelle qui lui est propre et dont la valeur est, pour une même ligne de résultat, variable d'un réseau fabriqué à l'autre en fonction des dispersions de fabrication, des moyens de commande de précharge pour commander le début et la fin de la précharge capacitive des dites lignes de résultat.

Un tel réseau est bien connu dans l'industrie de l'électronique où il trouve de nombreuses applications pour, notamment, la réalisation de mémoires (ROM, RAM) et de réseaux logiques programmables (PLA) comportant deux réseaux en cascade qui sont souvent dénommés : premier plan ET, deuxième plan OU.

Un exemple d'un tel réseau est décrit dans le brevet français n° 2 286 559; dans ce document, la précharge est débutée après un premier basculement d'un signal d'horloge puis, après un certain délai dont la durée dépend de la fréquence de l'horloge, la commande de la précharge est arrêtée et d'autres opérations sont effectuées; selon un principe physique connu, la durée utile de la précharge est proportionnelle à la valeur de la capacité à charger; compte-tenu des grandes dispersions de fabrication la durée du signal de commande de la précharge est, par mesure de sécurité, largement calculée mais, de ce fait, la vitesse de fonctionnement du réseau

- 2 -                    0231550

n'est pas optimale.

La présente invention a pour but de remédier à cet inconvénient.

Selon la présente invention, un réseau est particulièrement remarquable en ce que, il comporte en outre une ligne supplémentaire de résultat telle que d'une part elle est positionnée sur le substrat tout à fait à proximité des autres lignes de résultat de telle sorte qu'elle soit tout à fait soumise aux mêmes dispersions de fabrication que les dites lignes de résultat fabriquées simultanément, d'autre part elle est agencée pour que sa propre capacité réelle équivalente de précharge ait pour chaque réseau fabriqué une valeur légèrement supérieure à la plus forte des dites valeurs des dites lignes de résultat quelles que soient les dispersions de fabrication entre un réseau fabriqué et un autre.

Il y a lieu de préciser pourquoi il est possible d'avoir la certitude de pouvoir réaliser une capacité toujours supérieure aux autres; en effet il est connu qu'il existe de grandes dispersions de fabrication au sein d'une même tranche de substrat (waffer) sur laquelle plusieurs puces (chip) d'un même type sont réalisées; les trous, les impuretés, les épaisseurs,... varient d'une tranche à l'autre, d'un bout à l'autre d'une tranche, et aussi d'un coin à un autre d'une puce dont la taille n'excède pourtant pas 10 mm x 10 mm soit 100 mm$^2$; selon l'invention, il est remarquable d'observer que la surface d'un réseau est rarement supérieure à 500 µm sur 500 µm, d'en déduire que d'un coin à l'autre de cette surface restreinte les dispersions de fabrication sont grandement limitées, et de tirer parti de cette constatation pour concevoir qu'une ligne supplémentaire de résultat positionnée dans cette même surface restreinte, c'est à dire tout à fait à proximité des autres lignes de résultat, suivra obligatoirement les mêmes fluctuations que les lignes de résultat voisines.

Ainsi malgré les dispersions de fabrication qui changent les caractéristiques électriques, notamment les capacités, de chaque réseau fabriqué, même s'il s'agit de réseaux logiquement identiques, la ligne supplémentaire de résultat possédera toujours une capacité équivalente réelle de valeur légèrement supérieure à la plus forte des capacités équivalentes réelles des autres lignes de résultat situées à proximité sur la même surface restreinte.

Il est connu que la capacité équivalente d'une ligne de résultat est notamment fonction du nombre de transistors de sélection qui ont été prévus sur la dite ligne de résultat; pour réaliser une ligne supplémentaire ayant une capacité adéquate, il est avantageux selon l'invention de la munir d'un nombre suffisant de transistors de sélection. Il peut aussi être avantageux de la munir d'une capacité couplée à la masse, capacité dont la valeur est choisie adéquatement.

Dans la pratique, ces deux possibilités se complètent puisque, en technologie CMOS, une capacité peut être constituée, d'une manière simple, d'un transistor non connecté.

Dans tous les cas, la ligne supplémentaire de résultat est agencée pour avoir une capacité équivalente telle que son temps de charge sera toujours supérieur au temps de charge des autres lignes de résultat. Il en sera de même pour son temps de décharge.

Selon l'invention un réseau est particulièrement remarquable en ce que la dite ligne supplémentaire de résultat est d'une part munie de moyens de décharge pour être déchargée avant que la précharge ne soit débutée, d'autre part munie de moyens de détection de fin de précharge pour, lorsque la précharge a été débutée, détecter la fin de sa propre précharge et, dans ce cas, générer un signal stable de fin de précharge.

Ainsi le réseau génère lui-même un signal de fin de précharge et il n'est plus nécessaire d'attendre un signal d'horloge pendant une durée largement calculée comme susdit; subsidiairement la construction de l'horloge s'en trouve simplifiée.

Selon un mode préférentiel, un réseau comportant en outre des moyens de commande d'évaluation pour commander le début et la fin de l'évaluation des lignes de résultat est particulièrement remarquable en ce que d'une part la dite ligne supplémentaire de résultat est agencée pour conserver sa précharge pendant l'évaluation, d'autre part il comporte un système logique de connexion de fin de précharge premièrement pour transmettre le dit signal de fin de précharge aux dits moyens de commande de précharge pour y commander l'arrêt de la précharge, et deuxièmement pour transmettre le dit signal de fin de précharge aux dits moyens de commande d'évaluation pour y commander le début de l'évaluation.

Pour commander l'évaluation selon des moyens connus il faut disposer d'un signal stable c'est pourquoi la dite ligne supplémentaire doit conserver sa précharge ou, autrement dit, ne doit pas être elle-même évaluée; l'évaluation est généralement réalisée, ainsi que décrit dans le brevet déjà cité, en tirant à la masse, c'est à dire en déchargeant, les lignes de résultat dont au moins un transistor de sélection a été rendu passant par la présence d'un signal haut sur la ligne d'entrée correspondante. La conservation de la précharge de la ligne supplémentaire de résultat est réalisée, par exemple, en ne connectant pas les transistors de sélection éventuellement prévus; en technologie CMOS, cette non-connexion transforme, d'une manière simple comme susdit, un transistor en une capacité. Le système logique de connexion de fin de précharge est un système simple qui sera décrit plus loin.

Pour tirer le meilleur parti de l'invention, un réseau est particulièrement remarquable en ce que, il comporte en outre une autre ligne supplémentaire de résultat agencée, similairement à la ligne supplémentaire de résultat préexistante pour avoir une capacité réelle équivalente supérieure à chacune des lignes de résultat, cette autre ligne supplémentaire de résultat étant d'une part agencée pour perdre sa précharge lors de l'évaluation du réseau, d'autre part munie de moyens de détection de fin de décharge pour, lorsque l'évaluation a été débutée, détecter la fin de sa propre décharge et, dans ce cas, générer un signal stable de fin de décharge.

Ainsi la même invention est aussi exploitée pour similairement générer un signal de fin de décharge qui indique que toutes les lignes de résultat ont été évaluées et qu'elles sont donc prêtes pour un usage ultérieur; pour que la dite autre ligne supplémentaire de résultat perde sa précharge, il suffit, par exemple, de connecter deux transistors de sélection prévus sur deux lignes d'entrée complémentaires l'une de l'autre.

Le réseau complet ainsi réalisé est auto-régulé en ce sens que son fonctionnement ne nécessite qu'un top, ou coup d'horloge, de départ indiquant que les signaux présents sur les lignes d'entrée sont stables; cette auto-régulation constitue un progrès technique considérable puisque d'une part les signaux des lignes de résultat sont disponibles beaucoup plus rapidement et d'autre part aucun signal d'horloge intermédiaire n'est plus nécessaire.

Dans un mode préféré d'utilisation, un réseau selon l'invention est appliqué à une cascade de 'r' (r entier > 1, notamment r = 2) réseaux, les lignes de résultats d'un réseau 'i' constituant les lignes d'entrée du réseau 'i+1', la précharge des 'r' réseaux étant de préférence initialisée simultanément, le signal de fin de décharge d'un réseau 'i' étant transmis au moyen d'un système logique de connexion de fin d'évaluation au réseau 'i+1' pour y commander l'évaluation, et ainsi de suite jusqu'au dernier réseau dont le signal de fin de décharge indique que les sorties définitives sont prêtes sur ses propres lignes de résultat.

Ainsi il a été réalisé un réseau logique programmable (PLA) avec un plan ET et un plan OU dont les sorties sont disponibles avant la fin d'une seule phase d'horloge alors que les PLA connues nécessitent généralement trois phases.

La présente invention présente de nombreux avantages qui seront mieux compris à l'aide d'un exemple, non limitatif, d'une réalisation décrite à l'aide des dessins annexés suivants :

- La figure 1 représente le schéma d'une PLA selon l'invention.

- La figure 2 représente une PLA sur une puce pour montrer l'échelle.

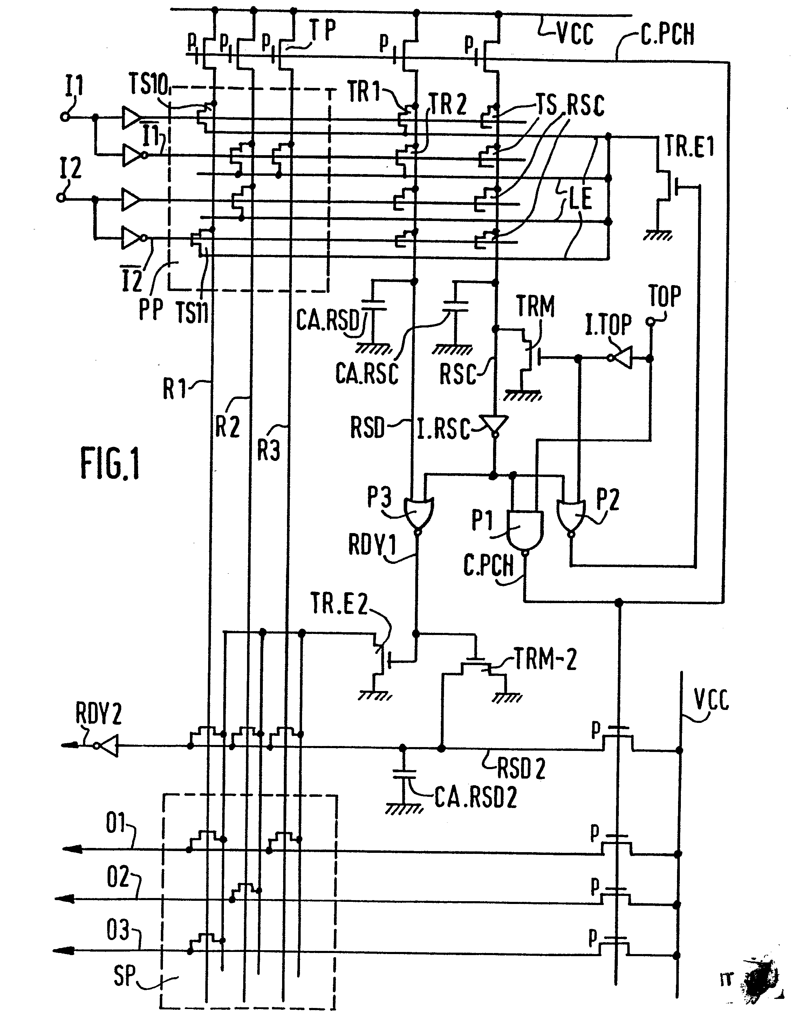

Sur la figure 1 est représentée une PLA qui comporte des éléments connus et des éléments nouveaux conformes à l'invention.

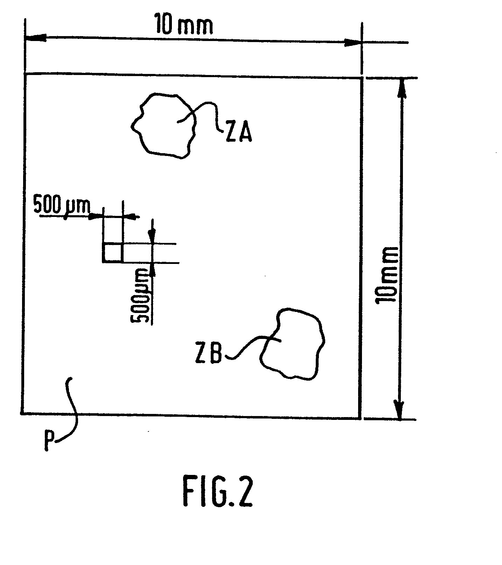

Parmi les éléments connus, l'homme du métier reconnaîtra deux réseaux appelés premier plan PP et second plan SP; les entrées du premier plan ($I_1$, $I_2$,...) sont complémentées ($\overline{I_1}$, $\overline{I_2}$,...) comme c'est l'usage, mais ceci n'est pas une obligation pour la réalisation de l'invention; les lignes de résultats (R1, R2, R3) du premier plan croisent les lignes d'entrée ($I_1$, $I_2$,...) et des transistors de sélection (TS10, TS11,...) sont prévus ou non à chaque croisement; chaque ligne de résultat est reliée à l'alimentation VCC par l'intermédiaire d'un transistor (TP) de type p dont la grille est connectée à la ligne C.PCH; la ligne C.PCH est la ligne de commande de précharge; lorsqu'elle transmet un signal de niveau bas, les transistors de type p sont passant et les lignes de résultats sont préchargées; la durée utile de la précharge de chaque ligne de résultat est fonction de sa capacité équivalente, laquelle capacité équivalente est notamment fonction d'une part du nombre de transistors de sélection prévus ou non, d'autre part des dispersions dues à la fabrication, dans le réseau premier plan PP selon l'invention une ligne supplémentaire de résultat (RSC) est prévue, elle est agencée pour avoir une capacité équivalente supérieure à chaque capacité équivalente des lignes de résultats habituelles; dans ce but, pour un premier mode de réalisation elle est munie d'un maximum de transistors de sélection (TS-RSC), pour un second mode de réalisation, combinable avec le premier, elle est munie d'une capacité (CA-RSC) adéquatement dimentionnée; on sait en effet par ailleurs que la valeur d'une capacité est proportionnelle à la surface de ses électrodes; quel que soit le mode de réalisation, l'important est d'obtenir une capacité équivalente de la ligne supplémentaire de résultat qui est toujours supérieure à la capacité équivalente de chacune des autres lignes de résultat quelles que soient les dispersions de fabrication; ce but est atteint, selon l'invention, et explicité sur la figure 2.

Sur la figure 2, une puce P est représentée à l'échelle 10; ses dimensions sont, par exemple, de 10mmx10mm et les caractéristiques physiques, et donc électriques, des différentes zones par exemple ZA et ZB sont différentes à cause de la distance qui les séparent; une PLA n'occupe généralement qu'une zone restreinte de, par exemple, 500 $\mu$m x 500 $\mu$m telle que représentée à l'échelle; selon l'invention, une ligne supplémentaire de résultat située dans la dite zone restreinte a les mêmes caractéristiques physiques, et donc électriques, que les autres lignes de résultat malgré les dispersions de fabrication car ces dispersions affectent dans les mêmes proportions tous les composants situés dans la dite zone restreinte. Il en résulte que la ligne supplémentaire RSC a toujours une capacité équivalente supérieure de sorte que son temps de charge et son temps de décharge sont toujours plus longs que pour les autres lignes.

Dans une première utilisation d'une telle ligne supplémentaire, un signal de fin de précharge est généré: étant donné un signal initial présent sur la ligne TOP, lequel signal passe du niveau bas au niveau haut lorsque le réseau est activé, avant l'activation du réseau, le signal TOP de niveau bas est utilisé avec des moyens de décharge pour décharger la ligne supplémentaire; sur la figure 1, le signal TOP est inversé par l'inverseur (I.TOP) et transmis à un transistor (TRM) qui est alors passant pour tirer la ligne RSC à la masse; lorsque le signal TOP passe au niveau haut, le réseau est activé à travers un système logique de connexion pour d'une part précharger les lignes de résultats et d'autre part détecter la fin de la précharge de la ligne supplémentaire de résultat; dans ce but, le transistor TRM n'est plus passant puisque sa grille reçoit un signal de niveau bas; par ailleurs, la porte NON-ET (P1) a une entrée reliée au signal TOP, niveau haut, et son autre entrée est connectée à l'inverse de la ligne RSC, donc niveau haut, elle délivre alors en sortie un signal de niveau bas qui est utilisé comme signal de commande de la précharge (C-PCH); il est clair que, lorsque le signal TOP est de niveau bas, la porte P1 délivre en sortie un signal de niveau haut de sorte que la précharge n'est pas commandée.

Maintenant que la précharge est commencée, toutes les lignes de résultats se chargent progressivement selon des durées différentes; la dernière à être préchargée est la ligne supplémentaire de résultat (RSC) et, lorsqu'elle atteint un niveau haut, l'inverseur (I-RSC) bascule et délivre en sortie un signal stable de fin de précharge de niveau bas.

Il est clair que le système logique de connexion exposé, inverseur I-TOP et I-RSC, transistor TRM, porte P1 n'est qu'un mode de réalisation parmi d'autres qui seraient équivalents pour délivrer des signaux fonctionnels selon l'invention.

Le signal de fin de précharge généré est maintenant utilisé par un système logique de connexion pour premièrement commander l'arrêt de la précharge et deuxièmement commander le début de l'évaluation; l'arrêt de la précharge ne nécessite pas de moyens supplémentaires que ceux précédemment décrits; en effet le signal de fin de précharge, niveau bas, est présent à l'entrée de la porte P1 dont la sortie est maintenant de niveau haut ce qui arrête la précharge; les moyens de commande, connus, de l'évaluation d'un réseau sont les lignes LE; lorsque les transistors de sélection (TS10, TS11) prévus sont activés par les signaux présents sur les lignes d'entrée, les lignes LE tirent à la masse les lignes de résultats dès que le transistor TR-E1 est passant sur l'ordre d'un signal, de niveau haut, de commande d'évaluation; ce signal est généré, selon l'invention, par la porte NON-OU (P2) dont une entrée est connectée à la sortie de l'inverseur I-TOP et l'autre entrée est connectée à la sortie de l'inverseur I-RSC; la sortie de la porte P2 est connectée à la grille du transistor TR-E1; ainsi tant que la ligne RSC a un niveau bas, la sortie de P2 est à un niveau bas, et dès que la ligne RSC est préchargée, les deux entrées de P2 sont à un niveau bas et la sortie de P2 passe à un niveau haut ce qui commande l'évaluation du réseau; le signal de commande de l'évaluation devant être stable pendant toute la durée de l'évaluation, il faut éviter que la ligne RSC soit elle-même évaluée car, dans ce cas, le signal de fin de précharge basculerait à nouveau; dans ce but, et notamment lorsque la capacité de la ligne supplémentaire de résultat RSC est obtenue au moyen d'un certain nombre de transistors de sélection (TS-RSC), il faut prendre la précaution de ne pas connecter ces transistors (TS-RSC) de telle sorte que la ligne RSC ne soit pas tirée à la masse pendant l'évaluation.

Le mode de connexion décrit, notamment la porte P2, n'est qu'un exemple non limitatif pour parvenir au but de l'invention.

Selon un mode préféré de réalisation de l'invention, le réseau est muni d'une autre ligne supplémentaire de résultat RSD pour détecter la fin de l'évaluation.

La ligne RSD est agencée, comme la ligne RSC, pour avoir une capacité équivalente plus grande que celle des autres lignes de résultat; la ligne RSD, contrairement à la ligne RSC, est connectée de telle sorte que, lors de l'évaluation, elle soit toujours tirée à la masse; ceci est réalisé, comme représenté, en connectant deux transistors de sélection TR1 et TR2 prévus sur deux lignes d'entrées complémentées ($I_1$ et $\overline{I_1}$); une autre réalisation, non représentée, serait, par exemple, de tirer directement à la masse la ligne RSD à travers un transistor dont la grille serait connectée au signal d'évaluation dont le niveau haut rendrait le transistor passant; quel que soit le mode de réalisation choisi, la ligne RSD, après avoir été préchargée, se décharge pendant l'évaluation et, en fin de décharge, se trouve à un niveau bas; la ligne RSD est connectée à une entrée d'une porte NON-OU (P3) dont l'autre entrée reçoit le signal inverse du signal RSC de sorte que, à la fin de la décharge, la sortie de la porte NON-OU (P3) fournit un signal haut significatif de ce que la décharge est terminée ce qui revient à dire aussi que le réseau a été évalué ou encore que les signaux présents sur les lignes de résultats sont valides et stables; le signal haut disponible à la sortie de la porte P3 est un signal stable de fin de décharge.

Le réseau ainsi réalisé, avec notamment les deux lignes supplémentaires de résultat RSC et RSD et le système logique de connexion pour commander la précharge et l'évaluation est auto-régulé; sa mise en oeuvre nécessite uniquement un signal de départ TOP; ce signal peut aussi être le signal d'horloge, comme dans les réseaux connus; le système logique de connexion est particulièrement simple à réaliser mais d'autres modes de réalisation sont possibles sans pour

0231550

- 11 -

autant sortir du cadre de l'invention; par exemple il peut être envisagé de n'utiliser qu'une seule ligne supplémentaire et de détecter d'une part la fin de sa précharge et d'autre part la fin de sa décharge pour générer les signaux de commande de précharge, de commande d'évaluation, et de résultats disponibles, dans ce cas le système logique de connexion serait différent de celui qui a été décrit sans pour autant sortir du cadre de l'invention.

En se référant maintenant au second plan SP de la PLA de la figure 1, la précharge des lignes de sortie (01, 02, 03) est commandée par le même signal C.PCH déjà utilisé pour le premier plan de sorte que les précharges des deux plans sont simultanées; dès que les signaux des lignes de résultats R1, R2, R3 du premier plan sont disponibles, le deuxième plan est évalué, pour ce faire le signal disponible à la sortie de la porte P3 est transmis à la grille du transistor TR-E2 de commande d'évaluation du deuxième plan; le principe de fonctionnement du deuxième plan est exactement similaire à celui du premier plan; pour le deuxième plan est ajoutée, selon l'invention, une ligne supplémentaire de résultat RSD2 pour générer, similairement à la ligne RSD du premier plan, un signal de fin d'évaluation du deuxième plan RDY2; les entrées du deuxième plan n'étant pas nécessairement complémentées, il est préférable de tirer à la masse la ligne RSD2 au moyen d'un transistor TRM2 dont la grille est commandée par la commande d'évaluation du deuxième plan RDY1, ce dispositif avait déjà été proposé, mais non représenté, pour le premier plan.

Dans le mode de réalisation décrit il y a deux réseaux, ou plans, en cascade dont les phases de fonctionnement, début, précharge, évaluation sont auto-régulées à partir d'un seul signal TOP; il est clair qu'un système de 'r' réseaux en cascade auto-régulée ne sort pas du cadre de l'invention.

Les capacités CA-RSD et CA-RSD2 ont été représentées pour montrer que, similairement à la capacité CA-RSC, toutes les lignes supplémentaires de résultat (RSC, RSD dans le premier plan, et RSD2 dans le deuxième plan) ont une capacité équivalente agencée pour être de valeur suffisante conformément à l'invention.

Dans l'exemple décrit, le deuxième plan est préchargé en simultanéité avec le premier plan, de ce fait, le deuxième plan ne comporte pas de première ligne supplémentaire de résultat pour détecter la fin de la précharge du deuxième plan; il est clair que cette disposition n'est pas satisfaisante dans le cas où la durée nécessaire à la précharge du deuxième plan est plus longue que celle du premier plan, une autre disposition est alors de prévoir l'implantation de la ligne de détection de fin de précharge dans le plan dont la précharge est la plus longue; en alternative, chaque plan peut aussi être muni de sa propre ligne autonome de détection de fin de sa propre précharge; de multiples combinaisons de ces diverses possibilités sont envisageables sans pour autant sortir du cadre de l'invention qui est atteint par l'obtention d'au moins un réseau auto-régulé au moyen d'au moins une ligne supplémentaire de résultat.

REVENDICATIONS :

1.      Réseau programmable réalisé en logique dynamique sur un substrat semi-conducteur, comportant 'n' (n entier positif) lignes d'entrée disposées pour croiser 'p' (p entier positif) lignes de résultat, 'k' ($1 \leqslant k \leqslant n.p$) transistors de sélection prévus ou non à chaque croisement de chacune des dites lignes d'entrée avec chacune des dites lignes de résultat, chaque ligne de résultat ayant une capacité équivalente réelle qui lui est propre et dont la valeur est, pour une même ligne de résultat, variable d'un réseau fabriqué à l'autre en fonction des dispersions de fabrication, des moyens de commande de précharge pour commander le début et la fin de la précharge capacitive des dites lignes de résultat caractérisé en ce que, il comporte en outre une ligne supplémentaire de résultat telle que d'une part elle est positionnée sur le substrat tout à fait à proximité des autres lignes de résultat de telle sorte qu'elle soit tout à fait soumise aux mêmes dispersions de fabrication que les dites lignes de résultat fabriquées simultanément, d'autre part elle est agencée pour que sa propre capacité réelle équivalente de précharge ait pour chaque réseau fabriqué une valeur légèrement supérieure à la plus forte des dites valeurs des dites lignes de résultat quelles que soient les dispersions de fabrication entre un réseau fabriqué et un autre.

2.      Réseau selon la revendication 1 caractérisé en ce que la dite ligne supplémentaire de résultat est couplée à la masse à travers une capacité adéquatement dimentionnée notamment en fonction du nombre des dits transistors de sélection prévus ou non pour chacune des dites lignes de résulat.

3.      Réseau selon la revendication 1 ou 2 caractérisé en ce que la dite ligne supplémentaire de résultat est elle-même munie de transistors de sélection dont le nombre est choisi en fonction de la capacité équivalente globale désirée pour la dite ligne supplémentaire de résultat.

4.      Réseau selon la revendication 1, 2 ou 3, caractérisé en ce que la dite ligne supplémentaire de résultat est d'une part munie de moyens de décharge pour être déchargée avant que la précharge ne soit débutée, d'autre part munie de moyens de détection de fin de précharge pour, lorsque la précharge a été débutée, détecter la fin de sa propre précharge et, dans ce cas, générer un signal stable de fin de précharge.

5. Réseau selon la revendication 4, comportant en outre des moyens de commande d'évaluation pour commander le début et la fin de l'évaluation des lignes de résultat, caractérisé en ce que d'une part la dite ligne supplémentaire de résultat est agencée pour conserver sa précharge pendant l'évaluation, d'autre part il comporte un système logique de connexion de fin de précharge premièrement pour transmettre le dit signal de fin de précharge aux dits moyens de commande de précharge pour y commander l'arrêt de la précharge, et deuxièmement pour transmettre le dit signal de fin de précharge aux dits moyens de commande d'évaluation pour y commander le début de l'évaluation.

6. Réseau selon la revendication 5, caractérisé en ce que, il comporte en outre une autre ligne supplémentaire de résultat agencée, similairement à la ligne supplémentaire de résultat préexistante, pour avoir une capacité réelle équivalente supérieure à chacune des lignes de résultat cette autre ligne supplémentaire de résultat étant d'une part agencée pour perdre sa précharge lors de l'évaluation du réseau, d'autre part, munie de moyens de détection de fin de décharge pour, lorsque l'évaluation a été débutée, détecter la fin de sa propre décharge et, dans ce cas, générer un signal stable de fin de décharge.

7. Application d'un réseau selon la revendication 6 à une cascade de 'r' (r entier > 1, notamment r = 2) réseaux, les lignes de résultats d'un réseau 'i' constituant les lignes d'entrée du réseau 'i+1', la précharge des 'r' réseaux étant de préférence initialisée simultanément, le signal de fin de décharge d'un réseau 'i' étant transmis au moyen d'un système logique de connexion de fin d'évaluation au réseau 'i+1' pour y commander l'évaluation, et ainsi de suite jusqu'au dernier réseau dont le signal de fin de décharge indique que les sorties définitives sont prêtes sur ses propres lignes de résultat.

FIG.1

0231550

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | IEEE JOURNAL OF SOLID-STATE CIRCUITS, vol. SC-16, no. 2, avril 1981, pages 103-107, IEEE, New York, US; C.M. LIN: "A 4 mum NMOS NAND structure PLA" * Figures 2a,2b; page 104, colonne de droite, ligne 33 - page 106, colonne de gauche, ligne 11 * | 1,3-5 | H 03 K  19/177 |
| | --- | | |
| Y | EP-A-0 145 357 (A.T.T.) * Figures 1,2; page 6, ligne 10 - page 7, ligne 37 * | 1,3-5 | |
| | --- | | |
| A | EP-A-0 023 329 (TOKYO SHIBAURA DENKI K.K.) * Figure 3; page 8, ligne 2 - page 10, ligne 12 * | 1-6 | |
| | --- | | DOMAINES TECHNIQUES RECHERCHES (Int. Cl 4) |
| A | IBM TECHNICAL DISCLOSURE BULLETIN, vol. 24, no. 6, novembre 1981, page 3103, New York, US; D.A. KLUGA: "Clocked PLA with dummy circuit forming clock pulse for inter-array driver with worst-case delay" | 1 | H 03 K G 11 C |
| | --- | | |
| P,Y | EP-A-0 174 397 (TEXAS INSTRUMENTS) * Figure 16; page 21 * | 1-6 | |
| | --- |  -/- | | |

Le présent rapport de recherche a été établi pour toutes les revendications

| Lieu de la recherche | Date d'achèvement de la recherche | Examinateur |
|---|---|---|
| LA HAYE | 15-04-1987 | FEUER F.S. |

Office européen
des brevets

**RAPPORT DE RECHERCHE EUROPEENNE**

| | **DOCUMENTS CONSIDERES COMME PERTINENTS** | | Page 2 |
|---|---|---|---|
| Catégorie | Citation du document avec indication, en cas de besoin, des parties pertinentes | Revendication concernée | CLASSEMENT DE LA DEMANDE (Int. Cl.4) |
| Y | GB-A-2 070 372 (TOKYO SHIBAURA DENKI K.K)<br>* Figures 3,4; page 2, ligne 106 - page 4, ligne 17 *<br><br>--- | 1-6 | |
| P,A | US-A-4 611 133 (PETERSON et al.)<br>* Figures 1,2; colonne 4, ligne 43 - colonne 5, ligne 57 *<br><br>----- | 1-6 | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 15-04-1987 | FEUER F.S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82